# EUROPEAN PATENT SPECIFICATION

(11) **EP 1 247 300 B1**
(45) Date of publication and mention of the grant of the patent: **11.10.2017**
(21) Application number: 00980162.2
(22) Date of filing: 07.11.2000
(51) Int. Cl.: H01L 27/07, H01L 29/772, H01L 27/098, H01L 29/24, H01L 29/06, H01L 29/16, H01L 29/808

(54) **A SEMICONDUCTOR DEVICE**
HALBLEITERANORDNUNG
DISPOSITIF A SEMI-CONDUCTEURS

(30) Priority: 27.12.1999 SE 9904785
(43) Date of publication of application: 09.10.2002
(73) Proprietor: Cree, Inc., Durham, NC 27703 (US)
(72) Inventor: BAKOWSKI, Mietek, S-151 60 Södertälje (SE); DAHLQUIST, Fanny, S-104 05 Stockholm (SE); LENDENMANN, Heinz, S-182 79 Stocksund (SE)
(74) Representative: Boult Wade Tennant
(86) International application number: PCT/SE2000/002170
(87) International publication number: WO 2001/048827

(56) References cited:
- EP-A2- 0 278 072
- US-A- 4 160 259
- US-A- 4 466 173
- US-A- 4 486 767
- US-A- 4 663 830
- NISHIZAWA J ET AL: "Field-effect transistor versus analog transistor (static induction transistor)", IEEE TRANSACTIONS ON ELECTRON DEVICES, IEEE SERVICE CENTER, PISACATAWAY, NJ, US, vol. ED-22, no. 4, 1 April 1975 (1975-04-01), pages 185-197, XP009140586, ISSN: 0018-9383, DOI: 10.1109/T-ED.1975.18103
- IWASAKI T. ET AL: "ELECTRICAL CHARACTERISTICS OF A NOVEL GATE STRUCTURE 4H-SIC POWER STATIC INDUCTION TRANSISTOR", MATERIALS SCIENCE FORUM, AEDERMANNSFDORF, CH, vol. 268, 1 January 1998 (1998-01-01), pages 1085-1088, XP002922595, ISSN: 0255-5476
- CASADY J.B. ET AL: "Status of silicon carbide (SiC) as a wide-bandgap semiconductor for high-temperature applications: a review", SOLID STATE ELECTRONICS, ELSEVIER SCIENCE PUBLISHERS, BARKING, GB LNKD- DOI:10.1016/0038-1101(96)00045-7, vol. 39, no. 10, 1 October 1996 (1996-10-01), pages 1409-1422, XP004012151, ISSN: 0038-1101

## Description

### TECHNICAL FIELD OF THE INVENTION AND PRIOR ART

The present invention relates to a semiconductor device according to claim 1. In an example, there is described a semiconductor device having on top of each other, in the order mentioned, at least the following layers: a drain contact, a drift layer being low doped according to a first conductivity type, n or p, a source region layer being highly doped according to said first type and a source contact, said device also comprising a first grid formed by a plurality of first regions being doped according to a second conductivity type being opposite to said first type, located in said drift layer and laterally separated by first drift layer portions, said first regions of said first grid having a first spacing selected to deplete said drift layer portions responsive to a voltage applied to said first grid, the device also comprising a second grid of a construction corresponding to that of the first grid arranged in said drift layer between the first grid and the drain contact at a vertical distance from the said first grid characterised in that said second grid comprises second regions having a second spacing that is greater than the first spacing of the first regions of the first grid.

The device may of course comprise further layers, such as a highly doped layer next to the drain contact for making a better contact thereto, or a buffer layer controlling the properties of the drain to drift layer transition. This drain may also have a doping opposite to that of said drift layer and would then mostly be called collector.

The invention is not restricted to any particular material of the layers of the device, but it is of particular interest for devices of wide-band gap type, i.e. materials having a wide energy gap between the valence band and the conduction band, and in particular SiC, and the invention will as a consequence thereof hereinafter be discussed for such a semiconductor device of SiC.

It is well known that SiC has some excellent physical properties, such as a high thermal stability, a high thermal conductivity and a high breakdown field being approximately ten times higher than for Si making SiC well suited as a material for high power devices operating under conditions where high voltages may occur in the blocking state of the device.

However, problems in the area of gate oxide reliability are still unsolved for MOS-devices of SiC and it is assumed that such devices will not achieve the properties necessary for semiconductor devices able to switch between said two states of blocking and conducting. This means that semiconductor devices of the type defined in the introduction, which has a JFET (Junction Field Effect Transistor) like structure are favoured. However, such JFET-device already known have some drawbacks. It is necessary to make the distance separating said regions of the grid very short and said regions very deep for obtaining a capability to block high voltages in said first state. A very low doping of the drift layer portions separating said regions is also necessary for obtaining this capability. This means that the on-state resistance of the device will be high resulting in high losses. The leakage current through the device when blocking higher voltages may also be unacceptably high. This means that the voltage gain, has to be rather low, so that such a device may not be made for high voltages without raising the gate voltage to a level producing high losses. The voltage gain is defined as voltage applied over the source contact and the grid in relation to the voltage possible to block over the source contact and the drain contact. Another drawback is that these devices may not be made normally off, i.e. they will be conducting at a gate voltage of 0 volts, since making them normally-off would result in a high on-state resistance for the design required for blocking high voltages in the blocking state.

A further drawback of such devices is, that higher voltages (say >5kV) cannot be achieved without bipolar modulation of the drift layer.

US 4160259 describes a transistor structure having a pair of current electrodes and a control electrode, at least one control electrode added to vary the negative feed-back resistance in the current path.

### SUMMARY OF THE INVENTION

The present invention provides a semiconductor device according to claim 1, which enables a considerable reduction of the drawbacks mentioned above associated with such devices already known.

This object is according to the invention obtained by providing such a device with a second grid of a construction corresponding to that of the grid first mentioned arranged in said drift layer between the first grid and the drain contact at a vertical distance from said first grid.

Such a connection of two grids in series, which in the practice in one possible embodiment means a series connection of two JFETs, makes it possible to address both of the drawbacks discussed above. The first grid may be designed to be able to hold comparatively low voltages in the blocking state of the device and the second grid may be designed to block a much higher voltage than the first grid, and it will then screen off the first grid from the high voltage and electric field. This means that the regions of the first grid may be made comparatively shallow and the doping concentration of the drift layer portions therebetween may be higher than it would be in the case the upper JFET alone have to block the voltage over the device, so that the on-state resistance of the device may be reduced. It would also be possible to construct the upper JFET with normally off properties. Furthermore, the voltage gain of the device will be increased considerably, i.e. a comparatively low voltage over the first grid and the source contact may allow a blocking of a voltage over the source contact and drain contact resulting from a multiplication of the gain of the two JFET-like structures connected in series. This low gate voltage will also reduce losses in the device, especially in high frequency operation thereof.

According to a preferred embodiment of the invention the device comprises means for adjusting a potential difference of each grid with respect to other parts of the device for regulating the width of the conducting channel between adjacent said regions of the grid in question. This may be achieved by two separate gate drive units, one for each grid, for individually controlling the potential of said regions of each grid, but according to a further embodiment of the invention the second grid is connected to the source contact, which means that this grid is always on the same potential as the source contact. This has several advantages. It means that there is only need for one gate drive unit connected to the first grid and arranged to cause the device to switch between a conducting state and a blocking state by applying different voltages on the first grid with respect to the source and bringing this grid between the second and the first state. This will simplify the constructions and the control of the device. Furthermore, it enables high frequency operation at low losses, since the main Miller-capacitance will be connected to the source contact and not to any gate drive unit of the device. This also means that a so called grid diode will be connected in antiparallel with the rest of the device, so that for instance in the case of using the device in a current valve in a converter no separate so called free-wheeling diode is needed, but this function will be integrated into the device itself.

According to another preferred embodiment of the invention the device also comprises a highly doped layer of said second conductivity type arranged directly on top of the drain contact for forming a bipolar transistor structure in the lower part of the device. This means that minority charge carriers will be introduced into the drift layer and contribute to the conduction in the on-state of the device, so that the on-state voltage will be lower and result in lower power losses. This may be utilized for making the low doped drift layer between the second grid and the drain contact thicker for obtaining a higher possible blocking voltage of the device while maintaining an acceptable low on-state voltage thereof.

According to another preferred embodiment of the invention the channels of the two grids are aligned to each other so that substantially vertical charge transport paths are formed between the source region layer and the drain contact. Such an alignment will reduce the on-state resistance of the device and thereby the conduction losses.

According to another preferred embodiment of the invention said first conductivity type is n and said second conductivity type is p, which is particularly advantageous for SiC, since the conductivity for electrons is considerably higher than for holes allowing higher current densities.

According to another preferred embodiment of the invention the doping concentration of the drift layer portion separating the two grids, the distance between the two grids, the doping concentration of the first regions of the second grid and the distance separating adjacent said regions of the second grid are selected so that a gradual increase of the voltage across the source contact and the drain contact, when the first grid is in a blocking state, will cause a depletion region of the second conductivity type moving from the first grid gradually towards the second grid to reach the second grid before the drift layer portions separating said first regions of the second grid have been completely depleted. This is advantageous for utilizing the blocking capacity of the JFET having said first grid to an optimum by letting the depletion region reaching the second grid before the voltage starts to build up in the second JFET-like structure.

Further advantages as well as advantageous features of the invention will appear from the following description and the other dependent claims.

### BRIEF DESCRIPTION OF THE DRAWINGS

With reference to the appended drawings, below follows a specific description of preferred embodiments of the invention cited as examples.

In the drawings:
- Fig 1: shows a schematic cross-section view of a semi-conductor device according a first preferred embodiment of the invention,
- Figs 2a and 2b: show the circuit symbols for the structure of Fig 1,
- Fig 3: is a schematic cross-section view of a semiconduc-tor device according to a second preferred embodiment of the invention,
- Fig 4: shows the circuit symbols for the structure according to Fig 3,
- Fig 5a: is a schematic cross-section view of a semiconduc-tor device according to a third preferred embodiment of the invention,
- Fig 5b: shows the circuit symbols for the structure of Fig 5a,
- Fig 5c: is a schematic cross-section view of a semiconductor device according to a fourth preferred embodiment of the invention,
- Fig 5d: shows the circuit symbols for the structure of Fig 5c,
- Figs 6-8: are cross-section views showing different steps of manufacturing a switching device according to the present invention,
- Fig 9: is a cross-section view illustrating a possible design of the upper JFET in a semiconductor device according to a preferred embodiment of the invention,
- Fig 10: is a view corresponding to Fig 9 of a part of a semiconductor device according to another preferred embodiment of the invention, and
- Fig 11: is a view corresponding to Fig 9 of a switching device according to a still further preferred embodiment of the invention.

### DETAILED DESCRIPTION OF PREFERRED EMBODIMENTS OF THE INVENTION

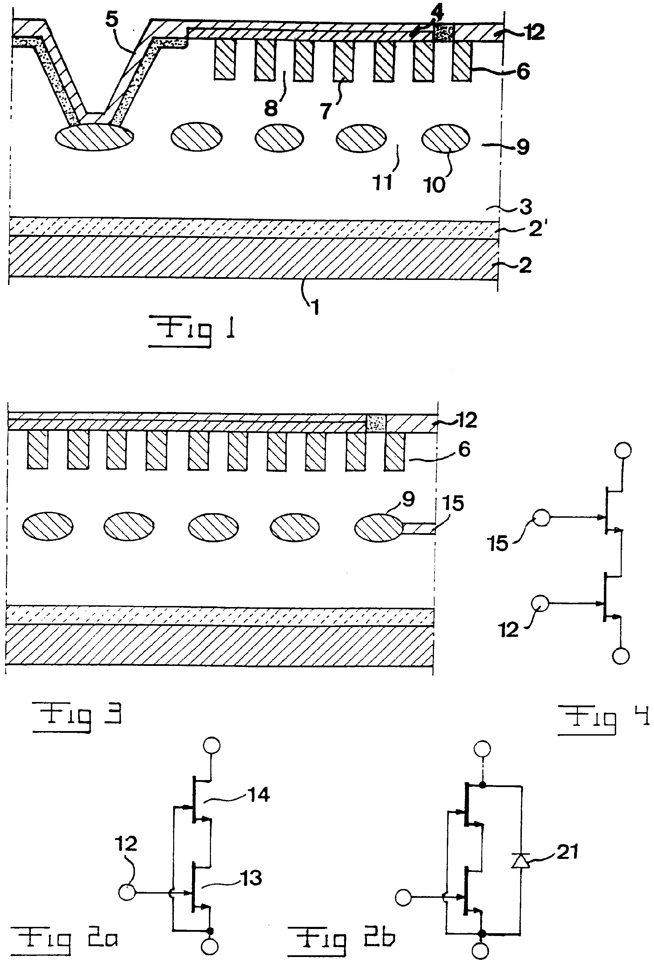

A semiconductor device made of SiC is schematically illustrated in Fig 1. However, it should be noticed that the relative dimensions of the regions in this device shown in this figure have only been chosen for the sake of clearness of the drawing. Such a device may for instance be used as a high power switch in a current valve of a converter, for example in a HVDC-station (High Voltage Direct Current). Voltages of 5 kV-1 MV may be handled by a plurality of such switches connected in series, while each switch may block voltages of 0.6-20 kV in the blocking state thereof.

This device has on top of each other in the order mentioned: a metal drain contact 1, a highly doped n-type substrate layer 2, an n-type buffer layer 2' controlling the properties of the drain to drift layer transistion and a low doped n-type drift layer 3. The doping concentration of the substrate layer 2 is preferably in the range of 10¹⁸-10²¹ (or 10¹⁸-10²⁰) cm⁻³ for making a good contact to the drain contact 1, whereas the doping concentration of the drift layer may be in the order of 10¹³-10¹⁶ cm⁻³. A highly doped n-type source region layer 4 is arranged on top of the drift layer for making a good contact to a metal source contact 5. The source region layer may have a doping concentration of 10¹⁸-10²¹ cm⁻³ (or 10¹⁸- mid10²⁰) cm⁻³.

A first grid 6 is formed near the source contact 5 close to the surface of the device by first regions 7 of p-type located in the drift layer and laterally separated by drift layer portions 8. The regions 7 are not in direct contact with the source region layer 4, but they are arranged as two grids displaced with respect to each other in the horizontal direction.

The device also comprises a second grid 9 having regions 10 of p-type buried in the drift layer and laterally separated by drift layer portions 11. Furthermore, the source contact 5 is connected to the second grid for giving this grid the same potential as the source contact. At 12 it is indicated where a gate drive unit is connected to the first grid for applying a certain potential thereto and accordingly a voltage with respect to the source contact for switching the device on or off.

The function of this device is as follows: We assume that the device is of normally on-type, which means that the first regions 7 of the first grid 6 are not able to deplete the drift layer portions 8 therebetween when a zero voltage V_{G} is applied across the source contact and the grid, but a conducing channel of n-type is formed between adjacent such regions 7. When a voltage V_{DS} is applied across the source contact and the drain contact a current will flow therebetween. However, the device may be switched off by applying a negative voltage to the first grid, for example in the order of -10V (or -20V), which will result in a total depletion of the drift layer portions 8, so that the grid 6 will be continuous and block current through the device. The device may be switched on and off by controlling the voltage on the first grid in this way. The main capacitance of the device will through the second grid 9 be connected to the source and not to the grid and the gate drive unit, which will considerably reduce the switching losses of the device making a high frequency operation with low losses possible.

The second grid 9 is designed for the situation in which the device has to block high voltages and supports the switching of the device in this case using a relatively high gate voltage. This means that the distances between adjacent regions 10 of this grid may be made larger than for the first grid, for example 1-6 µm compared to 0.3-3 µm. The presence of this lower second grid makes it possible to make the upper JFET having the first grid 6 of a low voltage type, i.e. with comparatively shallow first regions 7 resulting in a low on-state resistance thereof. This also makes it possible to make the device normally off and conducting when applying a low positive voltage on this grid 6 while maintaining a low on-state resistance.

When a high voltage is to be blocked by the device and is applied across the source contact and the drain contact for instance a negative voltage of -10 V is applied to the first grid for pinching the channels between the regions 7 off. We assume that the gain of the upper JFET is 20, which will then result in a gradual increase of the depletion region of the first grid by moving downwardly towards the second grid, so that a potential of about +200 V will result there and the upper JFET will hold this voltage. The regions 10 of the second grid will at the same time start to deplete the portions of the drift layer therebetween and when the drift layer regions 11 have been completely depleted and the second grid forms a continuous region of p-type this grid will screen off the upper JFET from the field of the lower JFET and a further increase of the voltage over the device. Accordingly, a further increase of the voltage as of said 200 volts will totally be taken by the lower JFET, which for instance may have a gain of 15 resulting in a possible blocking voltage of 3 kV assuming that the voltage at the second grid 9 is 200 V. Thus, the multiplication of the two gains, the double-grid structure and the function of the second grid to screen off the first grid from the high electric field will result in acceptably low leakage currents through the device also at very high voltages above 1 kV or even higher. The voltage taken by the upper JFET may of course in other embodiments be different from that mentioned above, for example 20V, 50V, 300V etc.

Accordingly, a device of this type having two JFETs 13, 14 in cascode connection as illustrated in Fig 2a may combine a low on-state resistance with a high voltage blocking capability, since the upper first grid 6 takes care of the switching of the device, whereas the lower JFET with the second grid 9 substantially takes care of the blocking of the device. An important feature for obtaining the excellent on-state properties is that the conducting channels through the grids are vertical. This should, however, not be interpreted as restricting the invention thereto, but a horizontal like channel could sometimes be preferable. The reason is, that eventually the design of the upper drift layer may be thin compared to the lateral dimensions, with a narrow and small pitch upper grid compared to a wider and larger pitch lower grid. It is illustrated in Fig 2b how a so called integrated grid diode 21 is formed in the device of Fig 1 through the connection of the second grid 9 to the source contact 5. This means that the device when used in for instance a current valve in a converter, for example in an HVDC-plant, makes an arrangement of a separate so called free-wheeling diode superfluous, since this diode function is here integrated in the device itself.

Figs 3 and 4 illustrate a device according to a second preferred embodiment of the invention differing from the one according to Fig 1 by the fact that the second grid 9 is not shorted to the source contact, but it has a gate drive unit 15 of its own. This will of course make the control of the device a little bit more complicated and also increase the losses of the device, so that the embodiment according to Fig 1 would mostly be preferred.

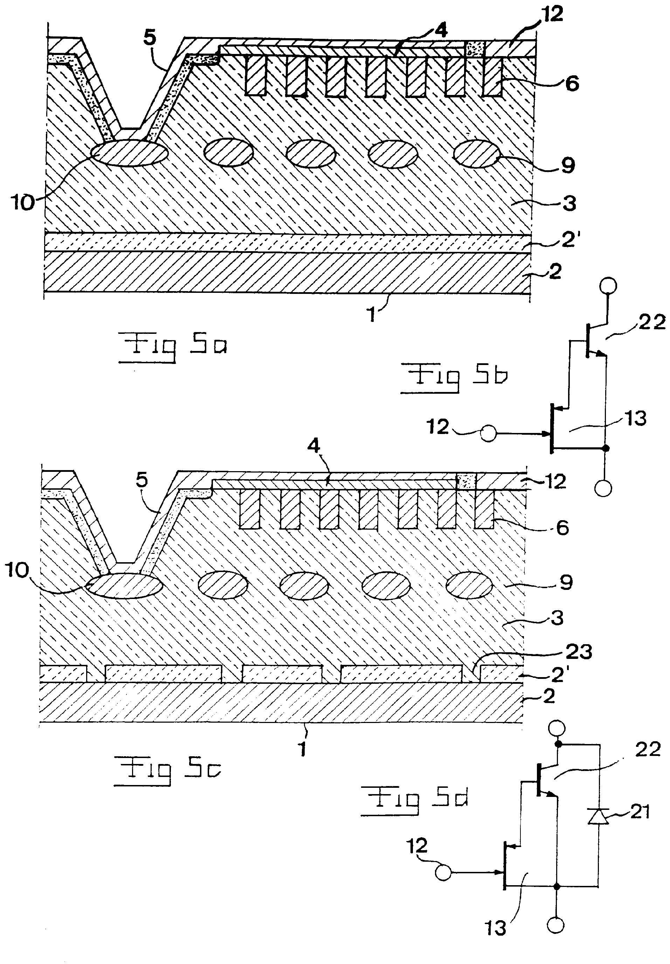

Fig 5a illustrates a device according to a third preferred embodiment of the invention, which differs from the one according to Fig 1 by the use of opposite doping types for the two grids 6, 9 (accordingly n-type) the source region layer 4, which here is a highly doped p-type layer, and the drift layer 3, which is a low doped p-type layer. However, the buffer layer 2' is an n-type layer forming a physical emitter, and the substrate layer 2 is a highly doped n-type layer. This means that this device is a bipolar device having an upper JFET-structure connected in series with a bipolar transistor structure of NPN-type formed by the grid 9, the drift layer 3 thereunder and the buffer layer 2'. This transistor will in the forward conducting state be switched on through a base current coming from the upper JFET-structure between the islands 10 of the second grid 9 and into the lower drift layer 3. At the same time minority charge carriers will be injected from the buffer layer 2' into the drift layer in said on-state of the device reducing the on-state resistance. This means that the drift layer region between the second grid 9 and the drain contact may be made thicker for a given on-state voltage over the device with respect to a device of the type shown in Fig 1, so that the voltage blocking capability will be improved.

The function of the device according to Fig 5a in the blocking state will be similar to that of the device according to Fig 1 in that the upper JFET-structure will result in a gradual increase of the depletion region of the first grid by moving downwardly towards the second grid, and this voltage built up in this way will eliminate said base current to the lower drift layer region or base of the bipolar transistor structure turning the transistor off. The circuit symbols for the structure of Fig 5a are shown in Fig 5b, where 22 is the bipolar transistor structure.

Fig 5c illustrates a device according to a fourth preferred embodiment of the invention differing from the one according to Fig 5a only by including so called "collector shorts" 23 in the form of regions of the drift layer reaching to the substrate layer 2. Such "collector" shorts are needed in a device of this type for making it possible to conduct in the reverse biased state through a grid diode structure formed by the contact between the source region layer and the lower grid. Accordingly, it is illustrated in Fig 5d how such a grid diode 21 is integrated also in this bipolar device. Another advantage of the so called collector shorts 23 is that they will reduce the transient losses and accordingly reduce the switching losses of the device, since the plasma formed in the bipolar NPN-structure in the forward conducting state will be reduced as a consequence of a reduction of plasma injection from the physical emitter formed by the buffer layer 2'. However, there is a trade off in the sense that this will also slightly increase the forward losses of the device.

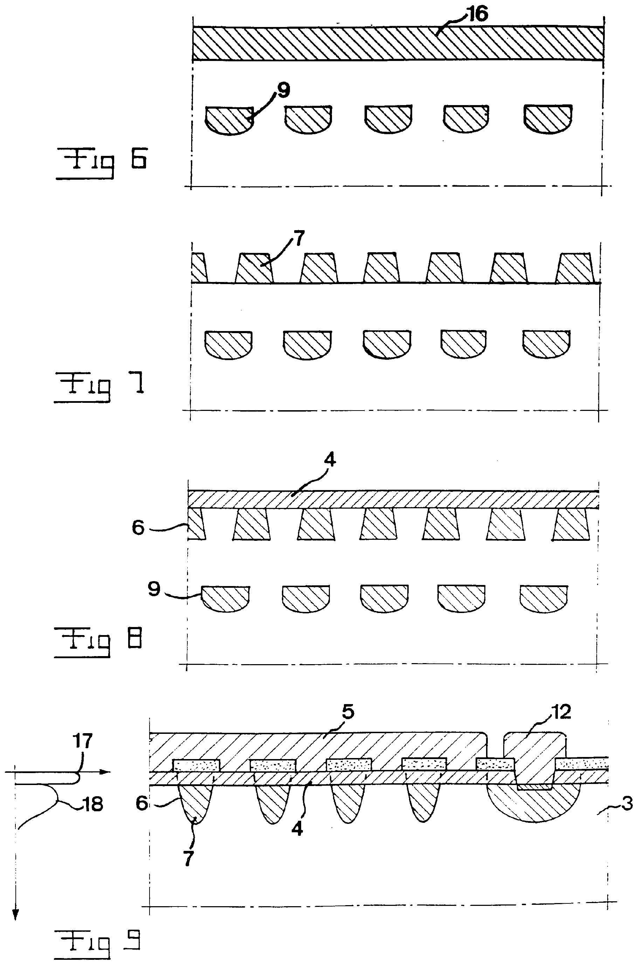

Figs 6-8 illustrate some of the processing steps for forming the two grids of a device of the type shown in Fig 1. The lower grid 9 may for instance be formed by masking, patterning and implantation of ions, for instance aluminium or boron, into the low doped drift layer. After removing the mask a regrowth of the drift layer above this grid may take place. It is then possible to choose a different doping concentration for this drift layer portion above the second grid than below this grid when desired. A p-type layer 16 may then be epitaxially grown on top of the drift layer, and after masking and patterning portions thereof will be etched away for forming the structure according to Fig 7. A further regrowth of the drift layer between the first regions 7 of the first grid may then take place. A mask may then be applied and patterned for growing a highly doped n-type source region layer 4 on top of the drift layer without making contact to the first grid 6.

Alternatively, for the formation of the lower grid a uniform layer doped to the grid dopant type may be formed first. Patterning is subsequently achieved by etching back selected areas to form the grid. The same sequence may be applied if the uniform layer was formed by epi growth. Also, the etch back can be the first step in the sequence followed by the formation of the p-type layer, either implant or epi. Together with such an etch back sequence, a planarization step may be used during or prior to the formation of the upper grid in order to create a flat contact surface.
The detailed sequences for the formation of the upper and lower grid may be the same or any combination of any of the steps outlined above.

Fig 9 shows another possible design of the upper grid of a device according to the invention, in which the portions corresponding to the portions of the device according to Fig 1 have been provided with the same reference numerals. The first regions 7 of this grid 6 have here been formed by ion implantation of acceptors after patterning the source region layer 4 formed before by epitaxial growth. The doping profiles of the source region layer 4 and the grid regions 7 are shown to the left, and the doping 17 of the source region layer may be 10¹⁹-10²⁰ cm⁻³, whereas the peak of the doping 18 of the grid will be 10¹⁸-10¹⁹ cm⁻³.

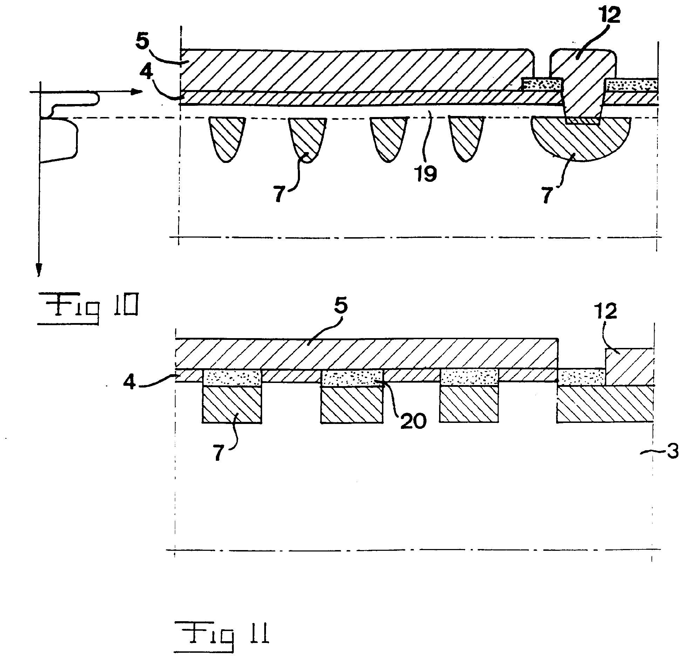

Fig 10 illustrates another way to form the upper part of a device according to the invention, in which the grid 6 is formed by ion implantation and then a low doped n-type drift layer portion 19 is epitaxially grown on top thereof, whereupon a highly doped n-type source region layer 4 is grown on top of the drift layer. The doping profile shows a doping concentration of about 10¹⁹-10²⁰ cm⁻³ for the source region layer, 10¹⁴-10¹⁶ cm⁻³ for the drift layer portions 19 and 10¹⁸-10¹⁹ cm⁻³ for the grid portions 7.

Finally, Fig 11 illustrates how the grid regions 7 may be formed by applying polysilicon of p-type in pits etched through the drift layer 3 and the source region layer 4 epitaxially grown. Insulating layers 20 are then applied on top of the regions 7 for electrically insulating the grid regions 7 with respect to the source region layer 4 and the source 5.

Accordingly, both grids 6, 9 may be formed by epitaxy or ion implantation.

The invention is of course not in any way restricted to the preferred embodiments described above, but many possibilities to modifications thereof will be apparent to a man with ordinary skill in the art without departing from the basic idea of the invention as defined in the appended claims.

It would for example be possible to change the conductivity type of the device, so that p-type will be n-type and conversely.

Furthermore, it is pointed out that a device according to the present invention has at least two grids, and more than two grids are accordingly conceivable. It could for instance be decided to have a further grid at the drain too in some particular application in the device, such as reverse and forward blocking devices as necessary in matrix converters.

It would also be possible to vary the doping concentration within any of the layers of the device and the doping profile for one or more layers may for instance be graded in a desired direction.

## Claims

1. A semiconductor device having on top of each other in the order mentioned at least the following layers :
a drain contact (1),
a drift layer (3) being low doped according to a first conductivity type, n or p,
a source region layer (4) being highly doped according to said first type, and
a source contact (5), the source contact being on the first side of the drift layer and the drain contact being on the opposite side of the drift layer,
said device also comprising a first grid (6) formed by a plurality of first regions (7) being doped according to a second conductivity type being opposite to said first type, located in said drift layer and laterally separated by drift layer portions (8), said first regions (7) of said first grid having a first spacing selected:
(a) to deplete said drift layer portions responsive to a first voltage applied to said first grid; and
(b) to form conducting channels of said first type between adjacent said first regions (7) of the first grid (6) and connect the source region layer with the drain contact via the drift layer, the drain contact being located on the opposite side of the drift layer responsive to a second voltage applied to said first grid,
the device also comprising a second grid (9) of a construction corresponding to that of the first grid arranged in said drift layer (3) between the first grid (6) and the drain contact (1) at a vertical distance from said first grid (6),
**characterized in that** said second grid (9) comprises second regions (10) having a second spacing that is greater than the first spacing of the first regions (7) of the first grid (6).

2. A device according to claim 1, **characterized in that** it comprises means (12,15) for adjusting a potential difference of each grid with respect to other parts of the device for regulating the width of the conducting channel between adjacent said regions of the grid in question.

3. A device according to claim 2, **characterized in that** said means is adapted to enable regulating of the potential difference between the source (5) contact and said first grid (6).

4. A device according to claim 3, **characterized in that** it comprises a gate drive unit (12) connected to the first grid (6) and arranged to cause the device to switch between a conducting state and a blocking state by applying the first and second voltages on the first grid with respect to the source contact (5).

5. A device according to any of claims 2-4, **characterized in that** said means are adapted to enable regulating of the potential difference between said first grid (6) and the second grid (9).

6. A device according to claim 1, **characterized in that** said second grid (9) is connected to the source contact (5) for giving this the second grid (9) the same potential as the source contact.

7. A device according to claim 1, **characterized in that** said first grid (6) is of normally-off type, wherein the first spacing of said first regions (7) is such that said drift layer portions (8) are fully depleted by said first regions (7), when no voltage is applied between the source contact (5) and said first grid (6).

8. A device according to any of claims 1 to 5 or claim 7, **characterized in that** said second grid (6) is normally on, which means that when no voltage is applied between the second grid and the source contact conducting channels of said first type are formed between adjacent second regions (10) of said second grid (9).

9. A device according to any of the preceding claims, **characterized in that** said drift layer has a lower doping concentration in the drift layer portions (8) separating said regions (7) of the first grid (6) than in second portions (11) separating said regions (10) of the second grid (9).

10. A device according to any of the preceding claims, **characterized in that** the doping concentration of the drift layer portions separating the two grids (6,9), the distance between the two grids, the doping concentration of the first regions (10) of the second grid and the distance separating adjacent said regions of the second grid are selected so that a gradual increase of the voltage across the source contact and the drain contact, when the first grid is in a blocking state, will cause a depletion region of the second conductivity type moving from the first grid gradually towards the second grid to reach the second grid before the drift layer portions separating said first regions of the second grid have been completely depleted.

11. A device according to any of claims 1-10, **characterized in that** it comprises a highly doped layer (2) of said first conductivity type arranged directly on top of the drain contact and a buffer layer (2') of said first conductivity type arranged between this layer and the drift layer (3).

12. A device according to any of claims 1-10, **characterized in that** it also comprises a highly doped layer of said second conductivity type arranged between the drain contact and the drift layer for forming a bipolar transistor (21) structure in the lower part of the device.

13. A device according to claim 12, **characterized in that** it comprises a buffer layer of said second conductivity type arranged between the drift layer and said highly doped layer of said second conductivity type.

14. A device according to claim 12, **characterized in that** said first conductivity type is p and said second conductivity type is n.

15. A device according to any of the preceding claims, **characterized in that** the channels of the two grids (6, 9) are aligned to each other so that substantially vertical charge transport paths are formed between the source region layer and the drain contact.

16. A device according to any of claims 1-13 and 15, **characterized in that** said first conductivity type is n and said second conductivity type is p.

17. A device according to any of the preceding claims, **characterized in that** both grids (6,9) are highly doped, i. e. they have a doping concentration exceeding 10¹⁷ cm⁻³.

18. A device according to any of the preceding claims, **characterized in that** the device has two JFET-structures following upon each other, and that the first one including the first grid is a normally off JFET (13) structure and the second including the second grid is a JFET (14) structure having a higher voltage and a lower gain than the normally off JFET (13) structure.

19. A device according to any of the preceding claims, **characterized in that** the first grid (6) and the drift layer between the first and second grid (9) has a capability to block a first blocking voltage of 30-300 V and the second grid (9) and the layer or layers of the device between the second grid and the drain contact (1) has a capability to block a second blocking voltage exceeding 1 kV.

20. A device according to claim 12 and 19, **characterized in that** said second blocking voltage is 1-25 kV.

21. A device according to claim 19 or 20, **characterized in that** said first blocking voltage is more than 20 times a blocking grid voltage applied on the first grid and said second blocking voltage is less than 20 times said first voltage.

22. A device according to any of the preceding claims, **characterized in that** the relationship of the distance separating adjacent grid regions (7) of the first grid (6) and the corresponding distance for the second grid (9) is smaller than 1.

23. A device according to any of the preceding claims, **characterized in that** the semiconductor layers of the device are made of a wide band gap material, i. e. a material having an energy gap between the valence band and the conduction band exceeding 1.5 eV.

24. A device according to claim 23, **characterized in that** the semiconductor layers of the device are made of SiC.

## Patentansprüche

1. Halbleitervorrichtung, die in der erwähnten Reihenfolge zumindest die folgenden Schichten aufeinander aufweist:
einen Drain-Kontakt (1),
eine Drift-Schicht (3), die gemäß einem ersten Leitfähigkeitstyp, n oder p, niedrig dotiert ist,
eine Source-Bereich-Schicht (4), die gemäß dem ersten Typ hoch dotiert ist, und
einen Source-Kontakt (5), wobei der Source-Kontakt auf der ersten Seite der Drift-Schicht ist und der Drain-Kontakt auf der entgegengesetzten Seite der Driftschicht ist,
wobei die Vorrichtung auch ein erstes Gitter (6) aufweist, das durch eine Mehrzahl von ersten Bereichen (7) gebildet ist, die gemäß einem zweiten Leitfähigkeitstyp, der dem ersten Typ entgegengesetzt ist, dotiert sind, in der Drift-Schicht angeordnet sind und durch Drift-Schicht-Abschnitte (8) seitlich getrennt sind, wobei die ersten Bereiche (7) des ersten Gitters einen ersten Abstand haben, ausgewählt:
(a) zum Verarmen der Drift-Schicht-Abschnitte in Antwort auf eine an das erste Gitter angelegte erste Spannung; und
(b) zum Bilden von leitenden Kanälen des ersten Typs zwischen den benachbarten ersten Bereichen (7) des ersten Gitters (6) und Verbinden der Source-Bereich-Schicht mit dem Drain-Kontakt über die Drift-Schicht, wobei der Drain-Kontakt auf der gegenüberliegenden Seite der Drift-Schicht angeordnet ist, in Antwort auf eine an das erste Gitter angelegte Spannung,
wobei die Vorrichtung auch ein zweites Gitter (9) einer Konstruktion, die jener des ersten Gitters entspricht, aufweist, das in der Drift-Schicht (3) zwischen dem ersten Gitter (6) und dem Drain-Kontakt (1) mit einem vertikalen Abstand von dem ersten Gitter (6) angeordnet ist,
**dadurch gekennzeichnet, dass** das zweite Gitter (9) zweite Bereiche (10) mit einem zweiten Abstand aufweist, der größer ist als der erste Abstand der ersten Bereiche (7) des ersten Gitters (6).

2. Vorrichtung nach Anspruch 1, **dadurch gekennzeichnet, dass** sie Mittel (12, 15) zum Einstellen einer Potentialdifferenz jedes Gitters in Bezug auf andere Teile der Vorrichtung aufweist, um die Breite des leitenden Kanals zwischen den benachbarten Bereichen des fraglichen Gitters zu regulieren.

3. Vorrichtung nach Anspruch 2, **dadurch gekennzeichnet, dass** das Mittel dazu ausgelegt ist, eine Regulierung der Potentialdifferenz zwischen dem Source-Kontakt (5) und dem ersten Gitter (6) zu ermöglichen.

4. Vorrichtung nach Anspruch 3, **dadurch gekennzeichnet, dass** sie eine Gate-Treibereinheit (12) aufweist, die mit dem ersten Gitter (6) verbunden und angeordnet ist, die Vorrichtung zu veranlassen, zwischen einem leitenden Zustand und einem Blockierzustand umzuschalten, durch Anlegen der ersten und zweiten Spannungen an das erste Gitter in Bezug auf den Source-Kontakt (5).

5. Vorrichtung nach einem der Ansprüche 2 bis 4, **dadurch gekennzeichnet, dass** die Mittel dazu ausgelegt sind, ein Regulieren der Potentialdifferenz zwischen dem ersten Gitter (6) und dem zweiten Gitter (9) zu ermöglichen.

6. Vorrichtung nach Anspruch 1, **dadurch gekennzeichnet, dass** das zweite Gitter (9) mit dem Source-Kontakt (5) verbunden ist, um diesem zweiten Gitter (9) das gleiche Potential wie dem Source-Kontakt zu geben.

7. Vorrichtung nach Anspruch 1, **dadurch gekennzeichnet, dass** das erste Gitter (6) vom Normal-Aus-Typ ist, wobei der erste Abstand der ersten Bereiche (7) derart ist, dass die Drift-Schicht-Abschnitte (8) durch die ersten Bereiche (7) vollständig verarmt werden, wenn zwischen dem Source-Kontakt (5) und dem ersten Gitter (6) keine Spannung angelegt wird.

8. Vorrichtung nach einem der Ansprüche 1 bis 5 oder Anspruch 7, **dadurch gekennzeichnet, dass** das zweite Gitter (6) Normal-Ein ist, was bedeutet, dass dann, wenn zwischen dem zweiten Gitter und dem Source-Kontakt keine Spannung angelegt wird, leitende Kanäle des ersten Typs zwischen benachbarten zweiten Bereichen (10) des zweiten Gitters (9) gebildet werden.

9. Vorrichtung nach einem der vorhergehenden Ansprüche, **dadurch gekennzeichnet, dass** die Drift-Schicht eine niedrigere Dotierungskonzentration in den Drift-Schicht-Abschnitten (8), die die Bereiche (7) des ersten Gitters (6) trennen, hat als in zweiten Abschnitten (11), die die Bereiche (10) des zweiten Gitters (9) trennen.

10. Vorrichtung nach einem der vorhergehenden Ansprüche, **dadurch gekennzeichnet, dass** die Dotierungskonzentration der Drift-Schicht-Abschnitte, die die zwei Gitter (6, 9) trennen, der Abstand zwischen den zwei Gittern, die Dotierungskonzentration der ersten Bereiche (10) des zweiten Gitters sowie der Abstand, der die benachbarten Bereiche des zweiten Gitters trennt, so ausgewählt sind, dass ein gradueller Anstieg der Spannung über dem Source-Kontakt und dem Drain-Kontakt, wenn das erste Gitter im Blokierzustand ist, bewirkt, dass sich ein Verarmungsbereich des zweiten leitfähigen Typs von dem ersten Gitter graduell zu dem zweiten Gitter bewegt, um das zweite Gitter zu erreichen, bevor die Drift-Schicht-Abschnitte, die die ersten Bereiche des zweiten Gitters trennen, vollständig verarmt worden sind.

11. Vorrichtung nach einem der Ansprüche 1 bis 10, **dadurch gekennzeichnet, dass** sie eine hochdotierte Schicht (2) des ersten leitfähigen Typs aufweist, die direkt oben auf dem Drain-Kontakt angeordnet ist, sowie eine Pufferschicht (2') des ersten leitfähigen Typs, die zwischen dieser Schicht und der Driftschicht (3) angeordnet ist.

12. Vorrichtung nach einem der Ansprüche 1 bis 10, **dadurch gekennzeichnet, dass** sie auch eine hochdotierte Schicht des Leitfähigkeitstyps aufweist, die zwischen dem Drain-Kontakt und der DriftSchicht angeordnet ist, um eine Bipolar-Transistor-Struktur (21) in einem unteren Teil der Vorrichtung zu bilden.

13. Vorrichtung nach Anspruch 12, **dadurch gekennzeichnet, dass** sie eine Pufferschicht des zweiten Leitfähigkeitstyps aufweist, die zwischen der Drift-Schicht und der hochdotierten Schicht des zweiten Leitfähigkeitstyps angeordnet ist.

14. Vorrichtung nach Anspruch 12, **dadurch gekennzeichnet, dass** der erste Leitfähigkeitstyp p ist und der zweite Leitfähigkeitstyp n ist.

15. Vorrichtung nach einem der vorhergehenden Ansprüche, **dadurch gekennzeichnet, dass** die Kanäle der zwei Gitter (6, 9) zueinander derart ausgerichtet sind, dass im Wesentlichen vertikale Ladungstransportwege zwischen der Source-Bereich-Schicht und dem Drain-Kontakt gebildet werden.

16. Vorrichtung nach einem der Ansprüche 1 bis 13 und 15, **dadurch gekennzeichnet, dass** der erste Leitfähigkeitstyp n ist und der zweite Leitfähigkeitstyp p ist.

17. Vorrichtung nach einem der vorhergehenden Ansprüche, **dadurch gekennzeichnet, dass** beide Gitter (6, 9) hoch dotiert sind, das heißt, sie eine Dotierungskonzentration haben, welche 10¹⁷ cm⁻³ überschreitet.

18. Vorrichtung nach einem der vorhergehenden Ansprüche, **dadurch gekennzeichnet, dass** die Vorrichtung zwei JFET-Strukturen aufweist, die aufeinander folgen, und dass die das erste Gitter enthaltende Erste eine Normal-Aus-JFET (13)-Struktur ist, und die das zweite Gitter enthaltende Zweite eine JFET (14)-Struktur ist, die eine höhere Spannung und eine geringere Verstärkung hat als die Normal-Aus-JFET (13)-Struktur.

19. Vorrichtung nach einem der vorhergehenden Ansprüche, **dadurch gekennzeichnet, dass** das erste Gitter (6) und die Drift-Schicht zwischen dem ersten und zweiten Gitter (9) eine Fähigkeit haben, eine erste Blockierspannung von 30 -300 V zu blockieren, und das zweite Gitter (9) und die Schicht oder die Schichten der Vorrichtung zwischen dem zweiten Gitter und dem Drain-Kontakt (1) die Fähigkeit haben, eine zweite Blockierspannung zu blockieren, die 1 kV überschreitet.

20. Vorrichtung nach Anspruch 12 und 19, **dadurch gekennzeichnet, dass** die zweite Blockierspannug 1-25 kV beträgt.

21. Vorrichtung nach Anspruch 19 oder 20, **dadurch gekennzeichnet, dass** die erste Blockierspannung mehr als das 20-fache einer an das erste Gitter angelegten Blockiergitterspannung ist, und die zweite Blockierspannung geringer als das 20-fache der ersten Spannung ist.

22. Vorrichtung nach einem der vorhergehenden Ansprüche, **dadurch gekennzeichnet, dass** die Beziehung des Abstands, der benachbarte Gitterabschnitte (7) des ersten Gitters (6) trennt, und des entsprechenden Abstands für das zweite Gitter (9) kleiner als 1 ist.

23. Vorrichtung nach einem der vorhergehenden Ansprüche, **dadurch gekennzeichnet, dass** die Halbleiterschichten der Vorrichtung aus einem Breitband-Lückenmaterial hergestellt sind, das heißt, einem Material, das eine Energielücke zwischen dem Valenzband und dem Leitungsband hat, die 1,5 eV überschreitet.

24. Vorrichtung nach Anspruch 23, **dadurch gekennzeichnet, dass** die Halbleiterschichten der Vorrichtung aus SiC hergestellt sind.

## Revendications

1. Dispositif à semi-conducteur ayant au moins les couches suivantes agencées les unes sur les autres dans l'ordre mentionné :
un contact de drain (1),
une couche de dérive (3) qui est faiblement dopée selon un premier type de conductivité, n ou p,
une couche de région source (4) qui est fortement dopée selon ledit premier type, et
un contact de source (5), le contact de source étant sur le premier côté de la couche de dérive et le contact de drain étant sur le côté opposé de la couche de dérive,
ledit dispositif comprenant également une première grille (6) formée par une pluralité de premières régions (7) qui sont dopées selon un deuxième type de conductivité qui est opposé audit premier type, située dans ladite couche de dérive et séparée latéralement par des parties (8) de couche de dérive, lesdites premières régions (7) de ladite première grille ayant un premier espacement sélectionné :
(a) pour appauvrir lesdites parties de couche de dérive en réponse à une première tension appliquée à ladite première grille ; et
(b) pour former des canaux conducteurs dudit premier type entre lesdites premières régions (7) adjacentes de la première grille (6) et pour relier la couche de région source au contact de drain par l'intermédiaire de la couche de dérive, le contact de drain étant situé sur le côté opposé de la couche de dérive en réponse à une deuxième tension appliquée à ladite première grille, le dispositif comprenant également une deuxième grille (9) d'une construction correspondant à celle de la première grille agencée dans ladite couche de dérive (3) entre la première grille (6) et le contact de drain (1) à une distance verticale de ladite première grille (6),
**caractérisé en ce que** ladite deuxième grille (9) comprend des deuxièmes régions (10) ayant un deuxième espacement qui est supérieur au premier espacement des premières régions (7) de la première grille (6).

2. Dispositif selon la revendication 1, **caractérisé en ce qu'**il comprend des moyens (12, 15) pour ajuster une différence de potentiel de chaque grille par rapport à d'autres parties du dispositif pour réguler la largeur du canal conducteur entre lesdites régions adjacentes de la grille en question.

3. Dispositif selon la revendication 2, **caractérisé en ce que** ledit moyen est adapté pour permettre la régulation de la différence de potentiel entre le contact de source (5) et ladite première grille (6).

4. Dispositif selon la revendication 3, **caractérisé en ce qu'**il comprend une unité d'attaque de grille (12) reliée à la première grille (6) et agencée pour amener le dispositif à commuter entre un état conducteur et un état de blocage en appliquant des première et deuxième tensions sur la première grille par rapport au contact de source (5).

5. Dispositif selon l'une des revendications 2 à 4, **caractérisé en ce que** lesdits moyens sont adaptés pour permettre la régulation de la différence de potentiel entre ladite première grille (6) et la deuxième grille (9).

6. Dispositif selon la revendication 1, **caractérisé en ce que** ladite deuxième grille (9) est reliée au contact de source (5) pour donner à cette deuxième grille (9) le même potentiel que le contact de source.

7. Dispositif selon la revendication 1, **caractérisé en ce que** ladite première grille (6) est de type normalement désactivé, où le premier espacement desdites premières régions (7) est tel que lesdites parties (8) de couche de dérive sont complètement appauvries par lesdites premières régions (7), lorsqu'aucune tension n'est appliquée entre le contact de source (5) et ladite première grille (6).

8. Dispositif selon l'une des revendications 1 à 5 ou la revendication 7, **caractérisé en ce que** ladite deuxième grille (6) est normalement activée, ce qui signifie que, lorsqu'aucune tension n'est appliquée entre la deuxième grille et le contact de source, des canaux conducteurs dudit premier type sont formés entre les deuxièmes régions (10) adjacentes de ladite deuxième grille (9).

9. Dispositif selon l'une des revendications précédentes, **caractérisé en ce que** ladite couche de dérive a une concentration de dopage inférieure dans les parties (8) de couche de dérive séparant lesdites régions (7) de la première grille (6) à celle dans les deuxièmes parties (11) séparant lesdites régions (10) de la deuxième grille (9).

10. Dispositif selon l'une des revendications précédentes, **caractérisé en ce que** la concentration de dopage des parties de couche de dérive séparant les deux grilles (6, 9), la distance entre les deux grilles, la concentration de dopage des premières régions (10) de la deuxième grille et la distance séparant lesdites régions adjacentes de la deuxième grille sont sélectionnées de sorte qu'une augmentation graduelle de la tension à travers le contact de source et le contact de drain, lorsque la première grille est dans un état de blocage, provoquera une région d'appauvrissement du deuxième type de conductivité passant de la première grille progressivement vers la deuxième grille pour atteindre la deuxième grille avant l'appauvrissement complet des parties de couche de dérive séparant lesdites premières régions de la deuxième grille.

11. Dispositif selon l'une des revendications 1 à 10, **caractérisé en ce qu'**il comprend une couche fortement dopée (2) dudit premier type de conductivité agencée directement sur une partie supérieure du contact de drain et une couche tampon (2') dudit premier type de conductivité agencée entre cette couche et la couche de dérive (3).

12. Dispositif selon l'une des revendications 1 à 10, **caractérisé en ce qu'**il comprend également une couche fortement dopée dudit deuxième type de conductivité agencée entre le contact de drain et la couche de dérive pour former une structure de transistor bipolaire (21) dans la partie inférieure du dispositif.

13. Dispositif selon la revendication 12, **caractérisé en ce qu'**il comprend une couche tampon dudit deuxième type de conductivité agencée entre la couche de dérive et ladite couche fortement dopée dudit deuxième type de conductivité.

14. Dispositif selon la revendication 12, **caractérisé en ce que** ledit premier type de conductivité est p et ledit deuxième type de conductivité est n.

15. Dispositif selon l'une des revendications précédentes, **caractérisé en ce que** les canaux des deux grilles (6, 9) sont alignés les uns par rapport aux autres de sorte que des chemins de transport de charge essentiellement verticaux soient formés entre la couche de région source et le contact de drain.

16. Dispositif selon l'une des revendications 1 à 13 et 15, **caractérisé en ce que** ledit premier type de conductivité est n et ledit deuxième type de conductivité est p.

17. Dispositif selon l'une des revendications précédentes, **caractérisé en ce que** les deux grilles (6, 9) sont fortement dopées, c'est-à-dire, elles ont une concentration de dopage supérieure à 10¹⁷ cm⁻³.

18. Dispositif selon l'une des revendications précédentes, **caractérisé en ce que** le dispositif a deux structures JFET qui se suivent, et **en ce que** la première structure comportant la première grille est une structure JFET normalement désactivée (13) et la deuxième structure comportant la deuxième grille est une structure JFET (14) ayant une tension supérieure et un gain inférieur par rapport à la structure JFET normalement désactivée (13).

19. Dispositif selon l'une des revendications précédentes, **caractérisé en ce que** la première grille (6) et la couche de dérive entre les première et deuxième grilles (9) ont la capacité de bloquer une première tension de blocage comprise entre 30 et 300 V et la deuxième grille (9) et la couche ou les couches du dispositif entre la deuxième grille et le contact de drain (1) ont la capacité de bloquer une deuxième tension de blocage supérieure à 1 kV.

20. Dispositif selon les revendications 12 et 19, **caractérisé en ce que** ladite deuxième tension de blocage est comprise entre 1 et 25 kV.

21. Dispositif selon la revendication 19 ou 20, **caractérisé en ce que** ladite première tension de blocage est supérieure à 20 fois une tension de grille de blocage appliquée sur la première grille et ladite deuxième tension de blocage est inférieure à 20 fois ladite première tension.

22. Dispositif selon l'une des revendications précédentes, **caractérisé en ce que** la relation de la distance séparant les régions de grille (7) adjacentes de la première grille (6) et de la distance correspondante pour la deuxième grille (9) est inférieure à 1.

23. Dispositif selon l'une des revendications précédentes, **caractérisé en ce que** les couches semi-conductrices du dispositif sont constituées d'un matériau à large bande interdite, c'est-à-dire, un matériau ayant une bande interdite entre la bande de valence et la bande de conduction supérieure à 1,5 eV.

24. Dispositif selon la revendication 23, **caractérisé en ce que** les couches semi-conductrices du dispositif sont constituées de SiC.
